# EUROPEAN PATENT APPLICATION

(11) **EP 4 614 561 A1**
(43) Date of publication of application: **10.09.2025**
(21) Application number: 25151887.4
(22) Date of filing: 15.01.2025
(51) Int. Cl.: H01L 23/367, H01L 23/40

(54) **ELECTRONIC DEVICE WITH WARPAGE MITIGATION AND METHOD THEREFOR**

(30) Priority: 07.03.2024 US 202418598009
(71) Applicant: NXP B.V., 5656 AG Eindhoven (NL)
(72) Inventor: JANSSEN, Johannes Henricus Johanna, 5656AG Eindhoven (NL); OFFERMANN, Bernd, 5656AG Eindhoven (NL)
(74) Representative: Colaiuda, Antonella

(57) **Abstract**

An electronic device with warpage mitigation is provided. The electronic device includes an electronic component mounted on a first major side of a device substrate and interconnected with a plurality of conductive traces of the device substrate. A heat sink having a raised feature is affixed with a second major side of the device substrate such that the raised feature is located below the electronic component.

## Description

### Background

### Field

This disclosure relates generally to semiconductor device packaging, and more specifically, to electronic devices with warpage mitigation and method of forming the same.

### Related Art

Today, there is an increasing trend to include sophisticated electronic devices in products and systems that are subject to extreme environmental conditions. These sophisticated electronic devices may include features for specific applications which may impact the configuration of the electronic device packages, for example. For some features and applications, the configuration of the electronic device packages may be susceptible to lower reliability, lower performance, and higher product or system costs. Accordingly, significant challenges exist in accommodating these features and applications while minimizing the impact on electronic devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified top-side-up cross-sectional view, an example electronic device with warpage mitigation at a stage of manufacture in accordance with an embodiment.
FIG. 2A, FIG. 2B, FIG. 3 and FIG. 4 illustrate, in simplified cross-sectional views, example embodiments of an electronic component of the electronic device in accordance with an embodiment.
FIG. 5 illustrates, in a simplified cross-sectional view, an alternative example electronic device with warpage mitigation at a stage of manufacture in accordance with an embodiment.
FIG. 6 illustrates, in a simplified flow diagram view, an example method of assembling the example electronic device in accordance with an embodiment.

### Detailed Description

Generally, there is provided, an electronic device having warpage mitigation. The electronic device may be configured for operation and/or storage at cryogenic temperatures (e.g., -153 °C. and lower). The electronic device includes an electronic component mounted on a first side of a device substrate and interconnected with conductive features of the device substrate. The device substate with mounted electronic component is attached to a heat sink. The heat sink includes a raised feature configured to mitigate warpage of the device substrate when subjected to cryogenic temperatures. The raised feature is in thermal contact with a second side of the device substrate directly opposite of the mounted electronic component. By forming the heat sink with raised feature in this manner, the heat sink substantially compensates for potential warpage caused by inherent mismatches in coefficient of thermal expansion (CTE) between the device substrate and the electronic device. Accordingly, the device substrate remains in thermal contact with the heat sink during exposure to cryogenic temperatures where extreme mismatches in CTE may occur. Maintaining thermal contact and conduction between the device substrate and the heat sink provide improved thermal dissipation, device performance and reliability across various temperature ranges including cryogenic temperatures.

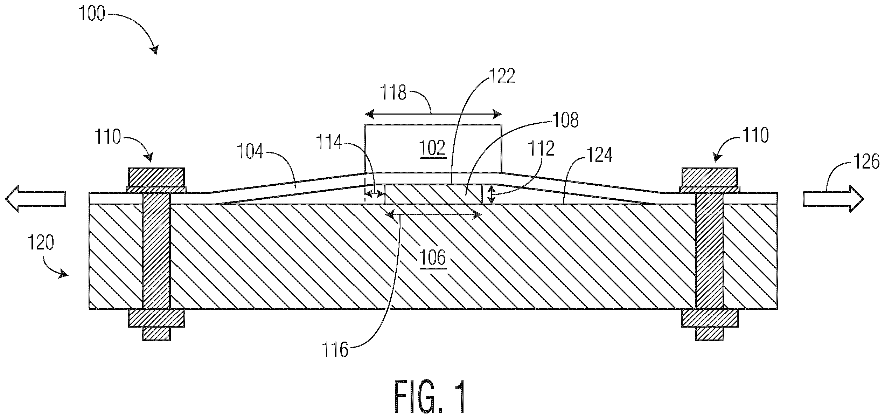

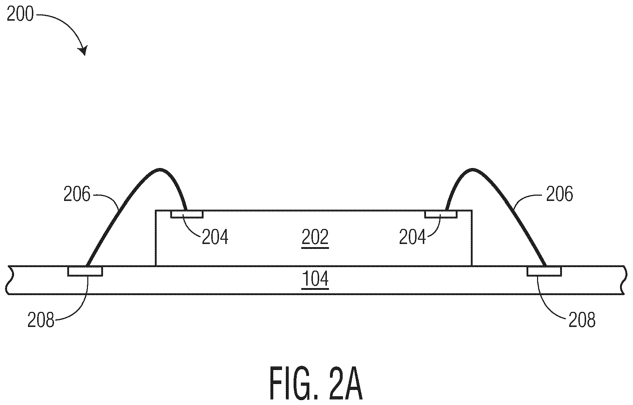

FIG. 1 illustrates, in a simplified top-side-up plan view, an example electronic device 100 with warpage mitigation at a stage of manufacture in accordance with an embodiment. At this stage, the electronic device 100 includes an electronic component 102 mounted on a device substrate 104, and the device substrate affixed to a heat sink 120. The electronic component 102 is mounted on a first major side of the device substrate 104 and interconnected with a plurality of conductive traces (not shown) of the device substrate. The term "conductive," as used herein, generally refers to electrical conductivity unless otherwise described. The electronic component 102 may include circuitry in the form of an integrated circuit suitable for operation at cryogenic temperatures. The heat sink 120 is affixed on a second major side of the device substrate 104 such that a raised feature 108 is located directly below the electronic component 102. The device substrate 104 may be affixed to the heat sink 120 by way of fasteners 110, for example. The size and shape of the electronic component 102 and corresponding raised feature 108 of the heat sink 120 in this embodiment are chosen for illustration purposes. Example implementations of the electronic component 102 are depicted in FIG. 2A, FIG. 2B, FIG. 3 and FIG. 4.

In this embodiment, the heat sink 120 includes a bulk portion 106 and the raised feature 108. The raised feature 108 extends vertically above the bulk portion 106. The raised feature may be formed as a plateau-like structure having a flat top surface 122 that is higher than surrounding top surface areas 124 of bulk portion 106 of the heat sink 120. For example, the plane at the top surface 122 of the raised feature 108 is located above the plane at the top surface 124 of the bulk portion 106 of the heat sink by a predetermined height 112. In this embodiment, the predetermined height dimension 112 may be in a range of approximately 500 microns to 2 millimeters. The heat sink 120 may be formed from a suitable material (e.g., copper, aluminum, diamond) or alloys thereof having good heat dissipation properties. In this embodiment, the raised feature 108 and the bulk portion 106 of the heat sink 120 are formed from a same contiguous material such as copper. In some embodiments, the raised feature 108 of the heat sink 120 may be formed separately and subsequently attached to the bulk portion 106 by way of a thermally conductive adhesive or solder.

In this embodiment, the area of the top surface 122 of the raised feature 108 is approximately in a range of 50% to 75% of the area of the bottom surface of the electronic device 102. By way of example for illustrative purposes, the raised feature 108 may be formed as a square shape having a width dimension 116 and a top surface area. In this example, the top surface area of the raised feature 108 is substantially equal to the dimension 116 multiplied by dimension 116 or (dimension 116)². Likewise, the electronic device 102 may be formed as a square shape having a device width dimension 118 and a bottom surface area. The bottom surface area of the electronic device is substantially equal to the dimension 118 multiplied by dimension 118 or (dimension 118)². Accordingly in this example, the width dimension 118 of the electronic device 102 may be approximately in a range of 1.15 to 1.4 times greater than the width dimension 116 of the raised feature 108. Because the area of the top surface 122 of the raised feature 108 is smaller than the area of the bottom surface of the electronic device 102, an outer perimeter portion of the electronic device overhangs the raised feature 108 by a predetermined overhang dimension 114. It may be desirable for the electronic device 102 to be aligned over the raised feature 108 such that the overhang dimension 114 is symmetrical or similar around the perimeter for optimal heat dissipation.

The device substrate 104 may be characterized as a laminate printed circuit board (PCB) in this embodiment. The device substrate 104 may be formed from as a plurality of electrically conductive and/or thermally conductive features (not shown) separated by a non-conductive material. In this embodiment, the device substrate 104 is formed from materials suitable for being subjected to cryogenic temperatures. The device substrate 104 with mounted electronic component 102 is pretensioned 126 (e.g., stretched) when affixed to the heat sink 120 in a manner without compromising the mechanical integrity of the device substrate. Because the device substrate 104 is pretensioned when affixed to the heat sink 120, a compression results between the device substrate 104 and raised feature 108 of the heat sink. In this embodiment, the device substrate 104 is configured to remain in thermal contact with the raised feature 108 of the heat sink 120 during exposure to cryogenic temperatures. In this embodiment, an air gap may exist between portions of the of the device substrate 104 and top surface portions of the bulk region 106 surrounding the raised feature 108 of the heat sink 120. In this embodiment a portion of the device substrate 104 is disposed directly between the electronic component 102 and the heat sink 120.

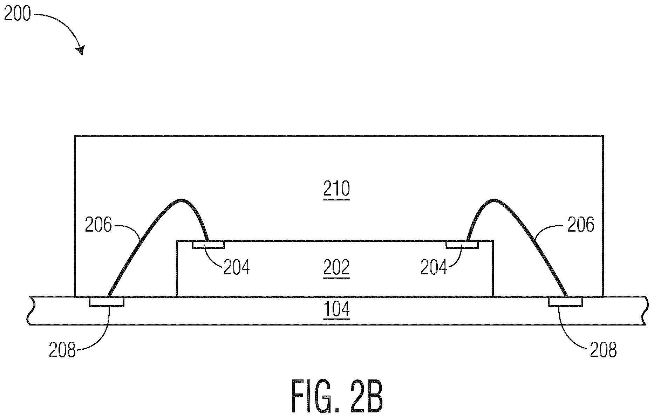

FIG. 2A and FIG. 2B illustrate, in simplified cross-sectional views, example embodiments of an electronic component 200 of the electronic device 100 depicted in FIG. 1 in accordance with an embodiment. In the embodiments of FIG. 2A and FIG. 2B, the electronic component 200 includes a semiconductor die 202 mounted on the device substrate 104 and interconnected with conductive traces 208 of the device substrate 104. A backside of the semiconductor die 202 is affixed to the device substrate 104 by way of a die attach adhesive or film (not shown). Bond pads 204 of the semiconductor die 202 are interconnected with the traces 208 by way of bond wires 206. In the embodiment depicted in FIG. 2B, the semiconductor die 202 and interconnecting bond wires 206 are over-molded with the encapsulant (e.g., epoxy molding compound) 210 by way of a molding process, for example.

The semiconductor die 202 has an active side (e.g., major side having circuitry, bond pads) and the backside (e.g., major side opposite of the active side). As depicted in the cross-sectional views of FIG. 2A and FIG. 2B, the semiconductor die 202 is in an active-side-up orientation, for example. In this embodiment, the semiconductor die 202 is configured for operation at cryogenic temperatures and may be formed from any suitable semiconductor material, such as silicon, germanium, gallium arsenide, gallium nitride, and the like. The semiconductor die 202 may further include digital circuits, analog circuits, RF circuits, power circuits, memory, processor, sensor, the like, and combinations thereof at the active side.

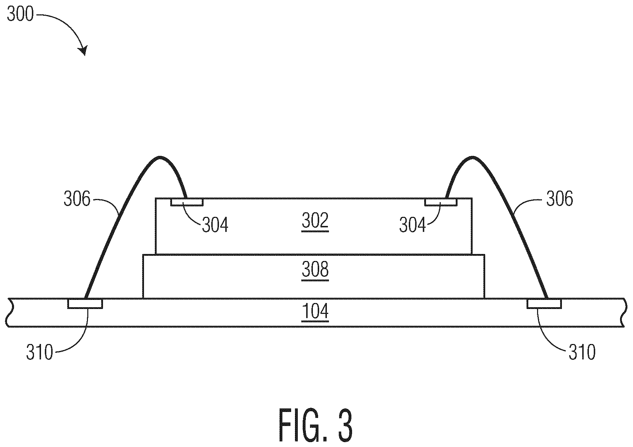

FIG. 3 illustrates, in a simplified cross-sectional view, another example embodiment of an electronic component 300 of the electronic device 100 depicted in FIG. 1 in accordance with an embodiment. In this embodiment, the electronic component 300 includes a semiconductor die 302 mounted on a spacer 308 which is affixed to the device substrate 104. The spacer 308 may be affixed to the device substrate 104 by way of a die attach adhesive or film (not shown). The spacer 308 may be formed from a suitable semiconductor material, such as silicon, sapphire, germanium, gallium arsenide, gallium nitride, and the like. It may be desirable for the thermal and mechanical properties of the spacer 308 to be similar to those of the semiconductor die 302. In some embodiments, the spacer 308 may be electrically conductive. The semiconductor die 302 is affixed to the device substrate 104 by way of a die attach adhesive or film (not shown). Bond pads 304 of the semiconductor die 302 are interconnected with traces 310 of the device substrate 104 by way of bond wires 306.

The semiconductor die 302 has an active side (e.g., major side having circuitry, bond pads) and a backside (e.g., major side opposite of the active side). As depicted in the cross-sectional view of FIG. 3, the backside of the semiconductor die 302 is mounted on the spacer 308 in an active-side-up orientation, for example. In this embodiment, the semiconductor die 302 is configured for operation at cryogenic temperatures and may be formed from any suitable semiconductor material, such as silicon, germanium, gallium arsenide, gallium nitride, and the like. The semiconductor die 302 may further include digital circuits, analog circuits, RF circuits, power circuits, memory, processor, sensor, the like, and combinations thereof at the active side.

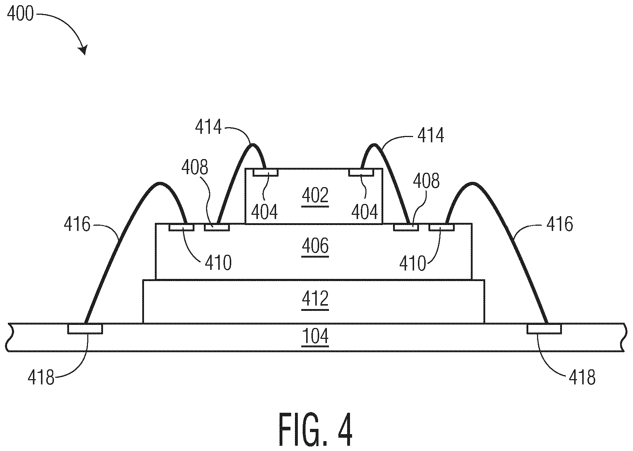

FIG. 4 illustrates, in a simplified cross-sectional view, another example embodiment of an electronic component 400 of the electronic device 100 depicted in FIG. 1 in accordance with an embodiment. In this embodiment, the electronic component 400 includes a semiconductor die 402 mounted on an interposer 406. The interposer 406 is affixed to a spacer 412 which is affixed on the device substrate 104. The interposer 406 may be formed from a silicon die, PCB or PCB-like substrate, for example. The interposer 406 is configured to provide conductive connections between the semiconductor die 402 and other active and/or passive devices (not shown) of the electronic component 400. For example, bond pads 404 of the semiconductor die 402 are interconnected with interposer traces 408 by way of bond wires 414 and interposer traces 410 are interconnected with conductive traces 418 of the device substrate 104 by way of bond wires 416. In addition, the interposer 406 is configured to provide common surface for mounting the semiconductor die 402 and other active and/or passive devices of the electronic component 400. The interposer traces 408 and 410 may be interconnected with one another and may be interconnected with the other devices of the electronic component 400. In this embodiment, the semiconductor die 402 is interconnected with the device substrate 104 by way of the interposer 406 and bond wires 414 and 416.

The semiconductor die 402 has an active side (e.g., major side having circuitry, bond pads) and a backside (e.g., major side opposite of the active side). As depicted in the cross-sectional view of FIG. 4, the backside of the semiconductor die 402 is mounted on the interposer 406 in an active-side-up orientation, for example. In this embodiment, the semiconductor die 402 is configured for operation at cryogenic temperatures and may be formed from any suitable semiconductor material, such as silicon, germanium, gallium arsenide, gallium nitride, and the like. The semiconductor die 402 may further include digital circuits, analog circuits, RF circuits, power circuits, memory, processor, sensor, the like, and combinations thereof at the active side.

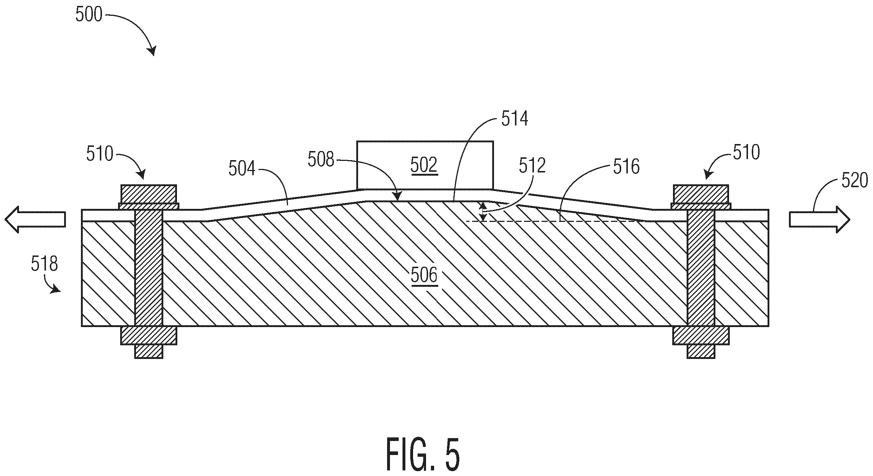

FIG. 5 illustrates, in a simplified top-side-up plan view, an alternative example electronic device 500 with warpage mitigation at a stage of manufacture in accordance with an embodiment. At this stage, the electronic device 500 includes an electronic component 502 mounted on a device substrate 504, and the device substrate affixed to a heat sink 518. The electronic component 502 is mounted on a first major side of the device substrate 504 and interconnected with a plurality of conductive traces (not shown) of the device substrate. Example implementations of the electronic component 102 depicted in FIG. 2A, FIG. 2B, FIG. 3 and FIG. 4 may be applicable to the electronic component 502, for example.

The heat sink 520 is affixed on a second major side of the device substrate 504. In this embodiment, the heat sink 518 includes a bulk portion 506 and an alternative raised feature 508. The raised feature 508 extends vertically above the bulk portion 506. The raised feature 508 may be formed as a pyramid-like or conical like shape having a flat top surface 514 that is higher than a plane of the surrounding top surface areas 516 of bulk portion 506. For example, the plane at the top surface 514 of the raised feature 508 is located above the plane at the outer perimeter top surface areas 516 of the bulk portion 506 of the heat sink 518 by a predetermined height 512. In this embodiment, the predetermined height dimension 512 may be in a range of approximately 500 microns to 2 millimeters. It may be desirable for the electronic device 502 to be aligned directly over the top surface 514 of the raised feature 508 for optimal heat dissipation. The heat sink 518 may be formed from suitable materials or alloys thereof having good heat dissipation properties at cryogenic temperatures. The device substrate 504 may be affixed to the heat sink 518 by way of fasteners 510, for example.

The device substrate 504 may be characterized as a laminate PCB in this embodiment. The device substrate 504 may be formed from as a plurality of electrically conductive and/or thermally conductive features (not shown) separated by a non-conductive material. In this embodiment, the device substrate 504 is formed from materials suitable for 5 cryogenic temperatures. The device substrate 504 with mounted electronic component 502 is pretensioned 520 (e.g., stretched) when affixed to the heat sink 518. Because the device substrate 504 is pretensioned when affixed to the heat sink 518, a compression results between the device substrate 504 and raised feature 508 of the heat sink. In this embodiment, the device substrate 504 is configured to remain in thermal contact with the raised feature 508 of the heat sink 518 during exposure to cryogenic temperatures. In this embodiment a portion of the device substrate 504 is disposed directly between the electronic component 502 and the heat sink 518.

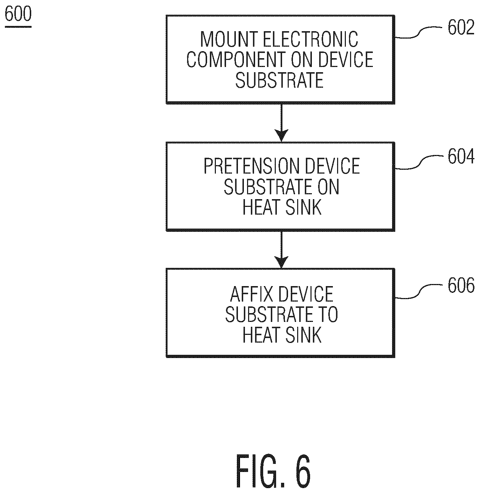

FIG. 6 illustrates, in a simplified flow diagram view, an example method 600 of assembling an example electronic device in accordance with an embodiment. The method 600 is consistent with the example electronic device 100 depicted in FIG. 1 and the alternative example electronic device 500 depicted in FIG. 5.

At step 602, mount electronic component on device substrate. In this embodiment, the electronic component is mounted on a first major side of the device substrate and interconnected with a plurality of conductive traces of the device substrate. Example embodiments of the electronic component are depicted in FIG. 2A, FIG. 2B, FIG. 3 and FIG. 4. The device substrate may be formed as a laminate PCB having a plurality of electrically conductive and/or thermally conductive features separated by a non-conductive material, for example. In this embodiment, the electronic component and the device substrate are configured for operation at cryogenic temperatures.

At step 604, pretension device substrate on heat sink. In this embodiment, the device substrate with mounted electronic component is pretensioned on the heat sink such that pressure is exerted between the raised feature and the device substrate. The pressure exerted between the raised feature and the device substrate forms a compression between the raised feature and the device substrate, for example. In this embodiment, the device substrate subtly deforms across the heat sink without adversely affecting the integrity of the device substrate or mounted electronic component when pretensioned.

At step 606, affix device substrate to heat sink. In this embodiment, the pretensioned device substrate with mounted electronic component is attached to the heat sink in a manner that results in a compression between the raised feature of the heat sink and the device substrate. The device substrate may be attached to the heat sink by way of fasteners, for example. By having the compression between the raised feature of the heat sink and the device substrate in this embodiment, the device substrate is configured to remain in thermal contact with the raised feature of the heat sink during exposure to cryogenic temperatures. Accordingly, potential device substrate warpage due to inherent mismatches in the CTE of the electronic device are substantially minimized.

Generally, there is provided, an electronic device including a device substrate having a plurality of conductive traces; an electronic component mounted on a first major side of the device substrate and interconnected with the plurality of conductive traces; and a heat sink having a raised feature, the heat sink affixed on a second major side of the device substrate such that the raised feature is located directly below the electronic component. The device substrate may be pretensioned before the heat sink is affixed on the second major side of the device substrate. The heat sink may be affixed on the second major side of the device substrate by way of one or more fasteners. The electronic component may overlap the raised feature by a predetermined distance. A top surface of the raised feature may be on a plane above a plane of a bulk portion of the heat sink. The raised feature and the bulk portion of the heat sink may be formed from a same contiguous material. The raised feature may be attached to the bulk portion of the heat sink. The electronic component may include a semiconductor die interconnected with the plurality of conductive traces. The electronic device may be configured for operation at cryogenic temperatures.

In another embodiment, there is provided, a method including mounting an electronic component on a first major side of a device substrate, the electronic component interconnected with a plurality of conductive traces of the device substrate; and affixing the device substrate on a heat sink, the heat sink having a raised feature in thermal contact with a second major side of the device substrate directly opposite of the electronic component mounted on the first major side of the device substrate. The device substrate may be pretensioned when affixing the device substrate on the heat sink such that pressure is exerted between the raised feature and the device substrate. The device substrate may be configured to remain in thermal contact with the raised feature of the heat sink during exposure to a cryogenic temperature. A width dimension of the electronic component may be greater than a width dimension of the raised feature by a predetermined distance. A top surface of the raised feature in thermal contact with the second major side of the device substrate may extend vertically from a plane of a bulk portion of the heat sink by a predetermined height. The electronic component mounted on the first major side of the device substrate may include a semiconductor die interconnected with the plurality of conductive traces of the device substrate.

In yet another embodiment, there is provided, an electronic device including a device substrate having a first major side and a second major side opposite of the first major side, a plurality of conductive traces formed at the first major side of the device substrate; an electronic component mounted on the first major side of the device substrate and interconnected with the plurality of conductive traces; and a heat sink having a raised feature, the heat sink affixed on the second major side of the device substrate such that the raised feature is in thermal contact with the second major side of the device substrate directly opposite of the electronic component mounted on the first major side of the device substrate. A width dimension of the electronic component may be greater than a width dimension of the raised feature by a predetermined distance. A top surface of the raised feature in thermal contact with the second major side of the device substrate may extend vertically from a plane of a bulk portion of the heat sink by a predetermined height. The electronic component mounted on the first major side of the device substrate may include a semiconductor die interconnected with the plurality of conductive traces of the device substrate. The device substrate may be configured to remain in thermal contact with the raised feature of the heat sink during exposure to a cryogenic temperature.

By now, it should be appreciated that there has been provided an electronic device having warpage mitigation. The electronic device may be configured for operation and/or storage at cryogenic temperatures (e.g., -153 °C. and lower). The electronic device includes an electronic component mounted on a first side of a device substrate and interconnected with conductive features of the device substrate. The device substate with mounted electronic component is attached to a heat sink. The heat sink includes a raised feature configured to mitigate warpage of the device substrate when subjected to cryogenic temperatures. The raised feature is in thermal contact with a second side of the device substrate directly opposite of the mounted electronic component. By forming the heat sink with raised feature in this manner, the heat sink compensates for potential warpage caused by inherent mismatches in CTE between the device substrate and the electronic device. Accordingly, the device substrate remains in thermal contact with the heat sink during exposure to cryogenic temperatures where extreme mismatches in CTE may occur. Maintaining thermal contact and conduction between the device substrate and the heat sink provide improved thermal dissipation, device performance and reliability across various temperature ranges including cryogenic temperatures.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. An electronic device comprising:
a device substrate having a plurality of conductive traces;
an electronic component mounted on a first major side of the device substrate and interconnected with the plurality of conductive traces; and
a heat sink having a raised feature, the heat sink affixed on a second major side of the device substrate such that the raised feature is located directly below the electronic component.

2. The electronic device of claim 1, wherein the device substrate is pretensioned before the heat sink is affixed on the second major side of the device substrate.

3. The electronic device according to any preceding claim, wherein the heat sink is affixed on the second major side of the device substrate by way of one or more fasteners.

4. The electronic device according to any preceding claim, wherein the electronic component overlaps the raised feature by a predetermined distance.

5. The electronic device according to any preceding claim, wherein a top surface of the raised feature is on a plane above a plane of a bulk portion of the heat sink.

6. The electronic device of claim 5, wherein the raised feature and the bulk portion of the heat sink are formed from a same contiguous material.

7. The electronic device of claim 5, wherein the raised feature is attached to the bulk portion of the heat sink.

8. The electronic device according to any preceding claim, wherein the electronic component includes a semiconductor die interconnected with the plurality of conductive traces.

9. The electronic device according to any preceding claim, wherein the electronic device is configured for operation at cryogenic temperatures.

10. A method comprising:
mounting an electronic component on a first major side of a device substrate, the electronic component interconnected with a plurality of conductive traces of the device substrate; and
affixing the device substrate on a heat sink, the heat sink having a raised feature in thermal contact with a second major side of the device substrate directly opposite of the electronic component mounted on the first major side of the device substrate.

11. The method of claim 10, wherein the device substrate is pretensioned when affixing the device substrate on the heat sink such that pressure is exerted between the raised feature and the device substrate.

12. The method of claim 10 or claim 11, wherein the device substrate is configured to remain in thermal contact with the raised feature of the heat sink during exposure to a cryogenic temperature.

13. The method according to claim 10 to claim 12, wherein a width dimension of the electronic component is greater than a width dimension of the raised feature by a predetermined distance.

14. The method according to claim 10 to claim 13, wherein a top surface of the raised feature in thermal contact with the second major side of the device substrate extends vertically from a plane of a bulk portion of the heat sink by a predetermined height.

15. The method according to claim 10 to claim 14, wherein the electronic component mounted on the first major side of the device substrate includes a semiconductor die interconnected with the plurality of conductive traces of the device substrate.
